# EUROPEAN PATENT APPLICATION

(11) **EP 1 932 938 A1**
(43) Date of publication of application: **18.06.2008**
(21) Application number: 06796353.8
(22) Date of filing: 11.08.2006
(51) Int. Cl.: C23C 14/24, C01G 1/00, C04B 35/45

(54) **TARGET FOR LASER ABRASION AND PROCESS FOR PRODUCING THE SAME**

(30) Priority: 31.08.2005 JP 2005252614
(71) Applicant: Dowa Mining Co., Ltd., Chiyoda-ku Tokyo 101-8617 (JP)
(72) Inventor: KOJIMA, Masahiro, Tokyo, 1018617 (JP)
(74) Representative: Grünecker, Kinkeldey, Stockmair & Schwanhäusser Anwaltssozietät
(86) International application number: PCT/JP2006/315915
(87) International publication number: WO 2007/026530

(57) **Abstract**

To provide an RE-based oxide superconducting sintered body that can be used as a target applicable to a laser ablation method without bonding it to a backing plate, and a manufacturing method of the same. Each kind of powder or solution is prepared, and when a composition formula of an RE-based oxide superconductor is expressed by REaBabCucOx, raw materials are weighed and mixed so as to satisfy a + b + c = 6, 0.95 < a < 1.05 and 1.505 = c / b < 1.6, and thereafter calcinations, pulverization, sintering, pulverization, and molding are carried out to obtain the RE-based oxide superconducting sintered body, and this RE-based oxide superconducting sintered body is used as a laser ablation target.

## Description

### TECHNICAL FIELD

The present invention relates to a laser ablation target used in preparing an oxide superconducting thin film, and to a method of manufacturing the same.

### BACKGROUND ART

Conventionally, means for preparing the oxide superconducting thin film includes a physical vapor-phase growth method represented by a sputtering method, and a chemical vapor-phase growth method represented by a CVD method. Then, the sputtering method using a sintered body obtained by sintering and fixing an oxide superconducting powder under a prescribed condition as a target, is effective for obtaining excellent superconducting characteristics of the obtained oxide superconducting thin film and a uniform composition. (see patent document 1, for example)

In recent years, development for applying an RE-based oxide superconducting thin film represented by YBa₂Cu₃Oₓ as a wire material has been actively carried out. (wherein RE refers to yttrium and/or a rare earth element such as Sm, Nd, Gd or Ho). Then, in each case of applying this wire material to a cable and applying it to a coil magnet, at least 1 km or more continuous superconducting thin film is desired, thus involving a technical problem that must be solved to improve a film forming speed of the superconducting thin film.

Under such a circumstance, the sputtering method is limited in improving the film forming speed, and a laser ablation method represented by a PLD method (pulse laser deposition method) having much higher speed than the sputtering method is focused, and a technical development therefore has been actively carried out. In this laser ablation method also, the superconducting thin film is continuously formed by using the sintered body obtained by sintering and fixing the oxide superconducting powder under a prescribed condition as a target, and directly irradiating this target with laser beams, thereby arranging a wire material substrate on a plume that rises on the target.

Patent Document 1: Japanese Unexamined Patent Application Publication No. H1-141867

Usually, the target used in the sputtering method is used in a state of being bonded to a backing plate manufactured by metal such as Cu (described as bonding hereunder.). In addition to fixing the target to a sputtering apparatus body, this backing plate also serves as efficiently releasing heat accumulated in the target to outside during sputtering. In addition, even when strain stress is added to the target which is heated by the aforementioned accumulated heat, thereby breaking this target when the target is a single body, this target has a strength against breakage because it is bonded to the backing plate and is structurally reinforced.

Similarly to sputtering methods as described above, the target bonded to the backing plate can be used as a laser ablation target in laser ablation methods.
However, when the oxide superconducting sintered body is bonded to the backing plate, there are problems as follows:
(1) Lots of man-hours are required for a bonding work, thus deteriorating productivity, requiring much time in manufacture, and prolonging a due date;
(2) A material cost is high, incurred in a bonding material such as indium or indium alloy generally, and in addition, miscellaneous costs such as a backing plate manufacturing cost and a bonding processing cost are required, resulting in increasing a production costs; and
(3) Basically only one side of the target can be used, because the other side of the target is bonded to the backing plate.
   These problems are possibly exposed in practical application and mass production of the laser ablation method.

In order to solve the above-described problems, the inventors of the present invention tries to use the RE-based oxide superconducting sintered body as a target for laser ablation, without bonding it to the backing plate. Here, in a case of the sputtering method, the RE-based oxide superconducting sintered body is used, having a composition of a + b + c = 6, a = 1.00, c/b = 1 .50, when the target is expressed by a general composition formula REaBabCucOx. This is because when the RE-based oxide superconducting sintered body having the aforementioned composition is used as a target, a superconducting thin film having excellent characteristics is considered to be obtained, because the RE-based oxide superconducting sintered body having this composition has almost no precipitated phase between oxide superconducting crystal grains of the oxide constituting this sintered body, and has excellent superconductivity.

However, as described above, in a case of the laser ablation target having no backing plate to efficiently release heat, and in this state when this laser ablation target is directly irradiated with laser beams and a plume is thereby generated, the temperature of the surface is rapidly increased, and the target is broken to pieces, because of a heat strain stress due to a thermal expansion difference in the target. To begin with, laser ablation methods includes a step of imparting energy to the target larger than the energy employed in above-described sputtering methods with the aim of markedly improving the film formation speed. While this is the cause of an increased thermal load on the target, the absence of a backing plate, which is effective for reducing this thermal load, is regarded as the cause of the target being easily broken down.

### DISCLOSURE OF THE INVENTION

Thereupon, an object of the present invention is to provide a laser ablation target applicable in laser ablation methods without bonding to a backing plate, and a method of manufacturing the same.

In order to solve the above-described problem, after strenuous study of inventors of the present invention, a technique of the present invention is achieved for the first time, whereby a strength against a heat strain stress due to a temperature variation of an RE-based oxide superconducting sintered body is largely increased, when an existential ratio of oxide superconductor crystal grains constituting the RE-based oxide superconducting sintered body contained in the laser ablation target, and a precipitated phase separated out between the oxide superconductor crystal grains, is controlled within a prescribed range, thus making it possible to use the RE-based oxide superconducting sintered body as the laser ablation target, without bonding the RE-based oxide superconducting sintered body to the backing plate.

That is to say, a first means for resolving the problem described above provides a laser ablation target containing an RE-based oxide superconducting sintered body expressed by a general formula REaBabCucOx (wherein RE denotes yttrium and/or a rare earth element), satisfying
a+b+c=6, 0.95<a<1.05 and 1.505≤c/b<1.6 with a precipitated phase of a copper oxide and/or a copper-containing oxide and/or a Ba-Cu compound that exists in a grain boundary of oxide superconducting crystal grains contained in the oxide superconducting sintered body.

A second means provides the laser ablation target according to first means, wherein an existence ratio of the aforementioned oxide superconducting crystal grains and the aforementioned precipitated phase is within a range from 98:2 to 85:15.

A third means provides
a method of manufacturing the laser ablation target according to first or second means, comprising the steps of:
weighing and mixing an RE element-containing raw material, a Ba-containing raw material and a Cu-containing raw material to obtain a mixture;
heating the mixture for 5 to 20 hours at 880°C to 960°C in an atmosphere containing 10 to 30% of oxygen to obtain a calcined powder;
compression molding the calcined powder to obtain a molded product; and
heating the molded product for 10 to 50 hours at 900°C to 980°C in an atmosphere containing 10 to 30% of oxygen to obtain an RE-based oxide superconducting sintered body,
   wherein
in the step of weighing and mixing the RE-containing raw material, the Ba-containing raw material, and the Cu-containing raw material to obtain a mixture, weighing and mixing are conducted so as to satisfy relationships α=6-β-γ, 0.95<α<1.05 and 1.6β>γ≥1.505β, where α is the number of moles of the RE element, β is the number of moles of Ba, and γ is the number of moles of Cu contained in the respective raw materials.

A fourth means provides
the method of manufacturing the laser ablation target according to first or second means, comprising the steps of:
weighing and mixing an RE element-containing raw material solution, a Ba-containing raw material solution and a Cu-containing raw material solution to obtain a mixed solution;
using a wet-type coprecipitation method to effect precipitation of a mixture containing the RE, Ba and Cu elements from the mixed solution;
heating the mixture for 5 to 20 hours at 880°C to 960°C in an atmosphere containing 10 to 30% oxygen to obtain a calcined powder;
compression molding the calcined powder to obtain a molded product; and
heating the molded product for 10 to 50 hours at 900°C to 980°C in an atmosphere containing 10 to 30% oxygen to obtain an RE-based oxide superconducting sintered body,
   wherein
in the step of weighing and mixing an RE-containing raw material solution, a Ba-containing raw material solution, and a Cu-containing raw material solution to obtain a mixed solution, weighing and mixing are conducted so as to satisfy relationships α = 6-β-γ, 0.95 < α < 1.05 and 1.6β > γ ≥ 1.505β, where α is the number of moles of the RE element, β is the number of moles of Ba, and γ is the number of moles of Cu contained in the respective raw materials.

A fifth means provides
the method of manufacturing the laser ablation target according to third or fourth means, comprising the steps of:
heating the calcined powder for 5 to 20 hours at 880ºC to 960ºC in an atmosphere containing 10 to 30% oxygen to obtain a sintered powder;
pulverizing the sintered powder to obtain a sintered powder of median diameter of 20µm or less; and
compression molding the pulverized sintered powder to obtain a molded product.

A sixth means provides
the method of manufacturing the laser ablation target according to any of third to fifth means, wherein in the step of heating the molded product to obtain an RE-based oxide superconducting sintered body, the oxygen partial pressure of the atmosphere during a temperature decreasing process after completion of the heating is 21% or more.

The laser ablation target of first or second means can be used as a laser ablation target without bonding to a backing plate.

According to the method of manufacturing the RE-based oxide superconducting sintered body of third or fourth means, it is possible to use a target containing the RE-based oxide superconducting sintered body, with a precipitated phase mainly composed of Cu generated between grains of the oxide superconducting crystal, as a laser ablation target without being bonded to a backing plate.

According to the method of manufacturing the laser ablation target of fifth means, by pulverizing the sintered powder to obtain a sintered powder of median diameter of 20µm or less, the density of the RE-based oxide superconducting sintered body can be raised, and a high-density laser ablation target can be manufactured.

According to the method of manufacturing the laser ablation target of sixth means, sufficient oxygen can be incorporated by the RE-based oxide superconducting sintered body contained in the target, and a thin film formed by using this target exhibits excellent superconductivity.

The composition and structure of the RE-based oxide superconducting sintered body contained in the laser ablation target according to the present invention will be hereinafter described.

### 1. Composition of the RE-based oxide superconducting sintered body

When the composition of the RE-based oxide superconducting sintered body contained in the laser ablation target according to the present invention is expressed by the general formula REaBabCucOx, the relationships of a + b + c = 6, 0.95 < a < 1.05, 1.505 ≤ c /b < 1.6 is satisfied. Here, the structure of the later-described precipitated phase generated in the RE-based oxide superconducting sintered body differs slightly between a case of a < 1 and a case of a ≥ 1. However, in both cases, it is possible to obtain an RE-based oxide superconducting sintered body of high strength against strain stress due to temperature variation. As a result, the target that can be applied to the laser ablation method singularly without being bonded to the backing plate can be obtained for the first time.

The case of a ≥ 1 be described.
From the viewpoint of a strength to the strain stress due to temperature variation, the relationship satisfying 1.505 = c / b is preferable. From the viewpoint of sufficiently maintaining the superconductivity of the obtained RE-based oxide superconducting thin film, this value preferably satisfies c / b < 1.60, or more preferably satisfies c / b < 1.560. Accordingly, 1.505 ≤ c / b < 1.60 is preferable and 1.505 ≤ c / b < 1.560 is more preferable. At this time, "a" also preferably satisfies 1.00 ≤ a < 1.05, and more preferably satisfies 1.01 ≤ a < 1.04, to achieve a balance between the viewpoint of the strength to the strain stress due to temperature variation and the viewpoint of sufficiently maintaining the superconductivity of the obtained RE-based oxide superconducting thin film.

Next, the case of a < 1 will be hereinafter described.
In this case also, in the same way as the case of a ≥ 1, 1.505 ≤ c / b < 1.60 is preferable, and 1.505 ≤ c / b < 1.560 is more preferable, to achieve a balance between the viewpoint of the strength to the strain stress due to temperature variation and the viewpoint of sufficiently maintaining the superconductivity of the obtained RE-based oxide superconducting thin film. In addition, 0.95 < a < 1.00 is preferable and 0.98 < a < 1.00 is more preferable. Accordingly, when both cases of a ≥ 1 and a < 1 are taken into consideration, 0.95 < a < 1.05 is preferable.

### 2. Structure of the RE-based oxide superconducting sintered body

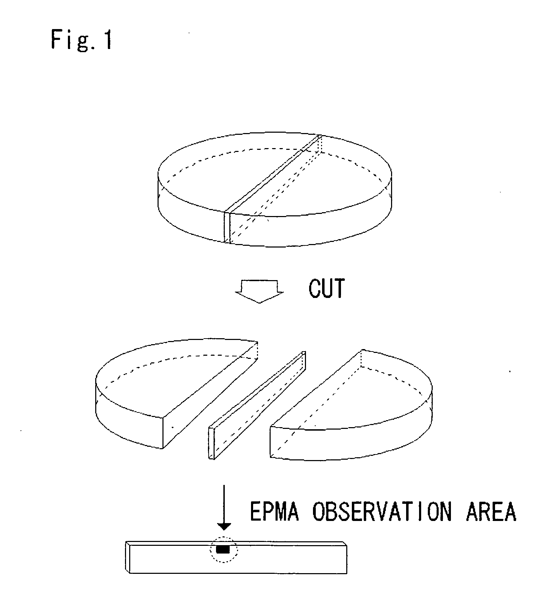

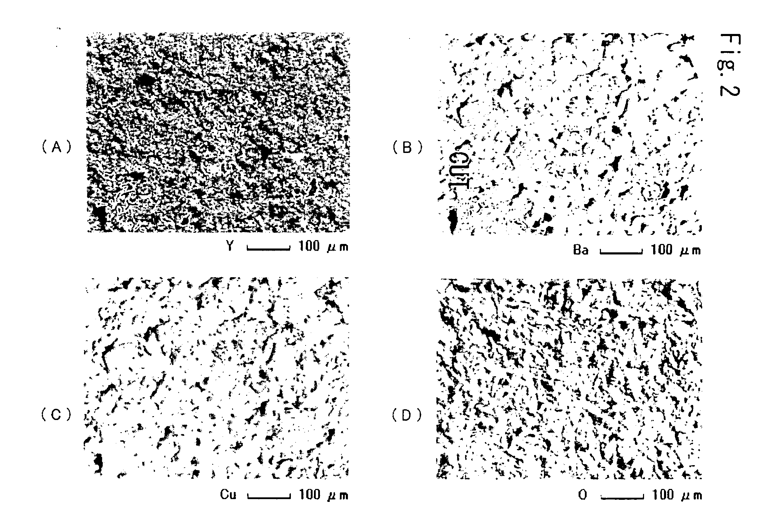

A structural analysis of the RE-based oxide superconducting sintered body described above was carried out.
More specifically, as shown in FIG. 1, a sample for structural analysis was cut from a central upper portion of a disc-shaped RE-based oxide superconducting sintered body sample. The structural analysis was executed by observing an in-surface distribution of each element of Y, Ba, Cu, and O of the same part of the sample by using an EPMA. FIG. 2 shows the measurement results thereof. FIG. 2(A) shows a Y content profile, (B) shows a Ba content profile, (C) shows a Cu content profile, and (D) shows an O content profile, wherein a high content portion of each element is bright, and a low content portion of each element is dark.

According to FIGS. 2(A) to (D), a region with low signal level observed in a mottled state, which is commonly observed in each element (namely, a dark region commonly observed in (A) to (D)). However, this region is a portion where the oxide superconducting crystal grains were lacked in a stage of sample preparation (during cutting), and this portion is considered to correspond to a recess portion that is recessed from an observation surface. Meanwhile, as a characteristic region, there is a region with high signal level (bright region) of (C)Cu and (D)O, while there is a region with low signal level of (A)Y and (B)Ba. These regions are shown by being surrounded by a white line in FIGS.2(A) to (D). The regions surrounded by a white line can be regarded as indicating regions in which a Cu-containing compound containing principally Cu is present as a precipitated phase between crystal grains of oxide superconducting crystal grains. In addition, it is estimated from the RE-based oxide superconducting sintered body usually manufactured in the atmospheric air, that the compound containing principally Cu can be regarded as copper oxide (CuO) and/or a copper-containing oxide and/or a Ba-Cu compound.

As described in "1. Composition of the RE-based oxide superconducting sintered body", the copper oxide (CuO) and/or Cu-containing oxide and/or Ba-Cu compound was generated by making a composition of the RE-based oxide superconducting sintered body deviated in a direction of Cu-rich from a stoichiometric state. In addition, the resistance to breakage due to increased thermal load caused by pulsed laser irradiation or the like and the markedly improved strength to strain stress caused by temperature variation of the RE-based oxide superconducting sintered body in which a compound containing principally Cu is present as a precipitated phase between the crystal grains of the oxide superconducting crystal grains was confirmed. This improvement in strength to strain stress caused by temperature variation of the oxide superconducting sintered body is considered to be a result of copper oxide (CuO) and/or Cu-containing oxide present between the oxide superconducting crystal grains fulfilling an adhesive-like role between the oxide superconducting crystal grains.

Here, when a is 1 or more, copper oxide (CuO) and/or a Cu-containing oxide was formed as a precipitated phase between the grains of an RE-based oxide superconducting crystal having a composition formula of RE_{1.02}Ba_{1.97}Cu_{3.01}Oₓ. In addition, at this time, the existence ratio of the oxide superconducting crystal grains and the precipitated phase is within a range from 98:2 to 85:15, and it is found that the strength against the strain stress and a sufficiently maintained superconductivity of the obtained RE-based oxide superconducting thin film can be compatible.

When a is less than 1, copper oxide (CuO) and/or a Cu-containing oxide and/or Ba-Cu compound represented by BaCuO₂ was formed as the precipitated phase between the RE-based oxide superconducting crystal grains having a composition formula of RE_{0.98}Ba_{1.99}Cu_{3.03}Oₓ.
In this case also, the precipitated phase containing the copper oxide, Cu-containing oxide, and Ba-Cu compound represented by BaCuO₂ serves as a joining material between the oxide superconducting crystal grains. As a result, it appears that the strength against the strain stress due to temperature variation is improved, as an entire body of the oxide superconducting sintered body. At this time also, similarly to the case of "a" is 1 or more, the existence ratio of the oxide superconducting crystal grains and the precipitated phase is in the range from 98:2 to 85:15. Thus it is found that the strength against the strain stress and the sufficient maintained superconductivity of the obtained RE-based oxide superconducting thin film can be compatible.

### 3. Method of manufacturing the laser ablation target according to the present invention

The method of manufacturing the laser ablation target according to the present invention will be hereinafter described.
Raw material powders of RE₂O₃, BaCO₃, and CuO are weighed and mixed to produce the desired molar ratio thereof. Specifically, when the number of mole of the RE element is a, the number of mole of Ba is β, and the number of mole of Cu is γ, which are contained in the raw materials, raw materials may be weighed and mixed in a range satisfying a=6-β-γ, 0.95<α<1.05 and 1.6β>γ≥1.505β. Namely, the raw materials are weighed, with a desired molar ratio set to satisfy a + b + c = 6, 0.95 < a < 1.05 and 1.505 = c /b < 1.6 when the target is expressed by REaBabCucOx. For example, when a = 1.020, b - 1.970 and c = 3.010 is satisfied, c/b = 1.528 is established.

The raw materials are mixed by using a wet type ball mill for 20 hours in an organic solvent. The thus-obtained slurry is put into a dryer. Then an organic solvent is sufficiently made to be volatile, and a mixture is obtained.

Also, the raw materials may be mixed, so that powders of each raw material are weighed and mixed, and in addition a raw material solution containing each element of RE, Ba, Cu is prepared and this raw material solution is mixed/adjusted to obtain a desired molar ratio, and the mixture containing each element of RE, Ba, Cu is precipitated from this mixed solution by a wet-type coprecipitation method, etc.

Next, the mixture is calcined in an atmosphere (for example, air) containing 10 to 30% oxygen (hereinafter in the description this is also referred to as the oxygen-containing atmosphere) to obtain a calcined powder. The mixture is heated under a calcination condition of 880°C to 960°C, more preferably 900°C to 950°C for 5 to 20 hours. It is possible to fill the obtained calcined powder in a later-described mold as it is, which is then pressure-molded into a molded body. However, from a viewpoint of making a composition uniform, as will be explained next, the raw material powders are preferably pulverized, then sintered again, and a sintered powders are thereby obtained.

The calcined powder is put in a ceramic pot together with a zirconia ball and an organic solvent such as toluene and ball pulverization is performed to this calcined powder. The calcined powder is more finely pulverized by this ball pulverizing operation, thus making it possible to improve uniformity of the calcined particles and increasing thermal reactivity of the calcined particles in the next sintering step.

Already pulverized slurry state calcined powders are dried by a dryer. The dried calcined powders are then heated and sintered for 5 to 50 hours at 880°C to 960°C, or more preferably 900°C to 950°C in an oxygen-containing atmosphere to obtain a sintered powder. The obtained sintered powder is put in a ceramic pot together with the zirconia ball and the organic solvent such as toluene, and is subjected to ball pulverization. This ball pulverizing operation is an operation so that the sintered powder has a particle size distribution suitable for manufacturing the RE-based oxide superconducting sintered body, and a pulverizing time is adjusted so that a median diameter of this sintered powder is set at 20 µm or less and preferably set at 10 µm or less. This is because when the median diameter of the sintered powder is set at 20 µm or less, preferably set at 10 µm or less, it is possible to sufficiently increase a density of the RE-based oxide superconducting sintered body as will be described later. A high performance laser ablation target of high density can be manufactured by increasing the density of the RE-based oxide superconducting sintered body.

The mold is filled with the obtained powder, which is then molded at a pressure of 1.0 to 2.0 tonne/cm². This pressure molding is preferably performed by a uniaxial molding. A thickness of the obtained molded body is preferably set at 5.0 to 7.0mm. Next, the molded product is arranged in a sintering furnace, and is heated and sintered for 10 to 50 hours at a temperature of 900°C to 980°C or more preferably 900°C to 940°C in an oxygen-containing atmosphere. An oxygen gas is preferably introduced into the sintering furnace in a temperature decreasing process after completion of heating. This is because by introducing oxygen into the firing furnace and setting an oxygen partial pressure of an atmosphere at 21% or more, the oxygen can be efficiently incorporated into the RE-based oxide superconducting sintered body, because the RE-based oxide superconducting sintered body generated by sintering the molded body has a property of discharging oxygen in the temperature increasing process and reversely incorporating oxygen in the temperature decreasing process. Also, this is because an excellent superconductivity is exhibited by a superconducting thin film which is formed, with the RE-based superconducting sintered body incorporating sufficient oxygen set as a target. Finally, only by cutting the obtained RE-based oxide superconducting sintered body into predetermined size, the target that can be applied to the laser ablation method singularly without being bonded to the backing plate can be obtained. Embodiments

### (Embodiment 1)

Each kind of powders Y₂O₃, BaCO₃ and CuO were prepared, and when the RE-based superconductor is expressed by a composition of YaBabCucOx, such each kind of powders are weighed and mixed, satisfying a=1.000, b=1.978, c=3.022 and (c/b=1.528).
Such each kind of powders were mixed and the mixture was stirred by using a wet-type ball mill for 20 hours in an organic solvent (toluene). A slurry thus obtained was put in a dryer, and the organic solvent is made to be volatile sufficiently.
The mixture was then set in a sintering furnace where it was heated and calcined for 10 hours at 900°C in an oxygen-containing atmosphere to obtain a calcined powder.

Next, the calcined powder was put in a ceramic pot together with a zirconia ball and toluene, and is subjected to ball pulverization. The calcined powder was finely pulverized, and uniformity is improved by this operation. By finely pulverizing the calcined particles to improve uniformity, thermal reactivity of the calcined powder can be increased in the next sintering step. Already ball-pulverized slurry state calcined powder is dried by a drier. The dried calcined powder was heated and sintered for 20 hours at 930°C in an oxygen-containing atmosphere to obtain a sintered powder. The obtained sintered powder was put in a ceramic pot together with the zirconia ball and toluene and was subjected to ball pulverization for 10 hours. As a result, a sintered powder of median diameter 8.0µm was obtained.

By filling the sintered powder after pulverization in a disc-shaped mold having a diameter of 100mmφ and by molding the sintered powder at a uniaxial molding pressure of 1.5 tonnes/cm², a molded body is obtained. The thickness of the molded body was 6.5mm. Next, the molded body was set in a sintering furnace and heated and sintered for 20 hours at a temperature of 930°C in an oxygen-containing atmosphere. Then, in the temperature decreasing process after completion of sintering, oxygen gas (2.0L/min.) was introduced into the sintering furnace to obtain an RE-based oxide superconducting sintered body sample A and it was used as a laser ablation target sample A with a size as it is.

Each kind of powder of Y₂O₃, BaCO₃ and CuO was prepared, and was weighed/mixed to obtain a = 1.000, b = 2.020, c = 2.980 (c/b = 1.475), when the RE-based oxide superconductor was expressed by a composition formula of BabCucOx, and by operating a similar operation to the aforementioned laser ablation target sample excluding the aforementioned mixing ratio, a laser ablation target sample B was obtained. Further, similarly sample C was obtained, with the mixing ratio set at a=1.000, b=1.962, c=3.038, (c/b=1.548), sample D was obtained, with the mixing ratio set at a=1.000, b=1.990, c=3.010, (c/b=1.513), sample E was obtained, with the mixing ratio set at a=1.000, b=1.996, c=3.004, (c/b=1.505), sample F was obtained, with the mixing ratio set at a=1.000, b=1.998, c=3.003, (c/b=1.503), sample G was obtained, with the mixing ratio set at a=1.000, b=2.000, c=3.000 (c/b=1.500), sample H was obtained, with the mixing ratio set at a=1.000, b=2.013, c=2.987, (c/b=1.484), and sample I was obtained, with the mixing ratio set at a=1.000, b=2.037, c=2.963, (c/b=1.455).

Regarding the obtained samples A to I of the laser ablation target, a 3-point bending test of fine ceramics was conducted, and strengths of both samples against mechanical distortion were compared. This is because there is a positive correlative relationship between the strength against a strain stress due to temperature variation and the strength against a mechanical distortion.
The test of strength against mechanical distortion was conducted pursuant to JISR 1601 "fine ceramic bending strength testing method", and a 3-point bending strength (σb3) was measured.
Wherein conditions are set as follows: inter-fulcrum distance:30mm, crosshead moving speed:0.5mm/minute, sample length:40mm, sample width:4.0mm, sample thickness:3.0mm, the number of test pieces:10.
A result of this test shows the 3-point bending strength (σb3) as follows: Sample A 88.9N/mm², Sample B 43.1N/mm², Sample C 88.7N/mm², Sample D 84.5N/mm², Sample E 76.4/mm², Sample F 48.0N/mm², Sample G 42.2N/mm², Sample H 46.3N/mm², and Sample I 41.8N/mm².

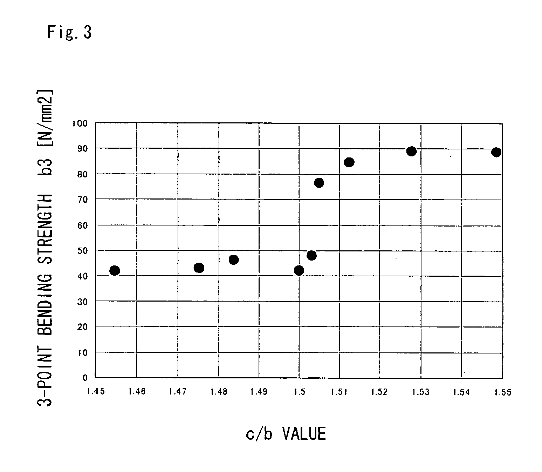

FIG. 3 shows the 3-point bending strength test results. FIG.3 is a graph, with values of the 3-point bending strength (σb3) taken on the vertical axis by a unit of N/mm2, and values of c/b in each sample taken on the horizontal axis. It is found from FIG.3, that as a result of the 3-point bending strength test of the sample, the 3-point bending strength is largely improved when the value of c/b is 1.505 or more. As a result, while the test result of sample A shows 88.9N/mm², the test result of sample B shows 43.1N/mm² and, accordingly it is found that sample A has a 3-point bending strength more than twice that of sample B. This result shows that the strength of samples A, C, to E against the mechanical distortion is more largely improved than that of the samples B, F to I. Accordingly, it appears that the strengths of the samples A, C, to E against the strain stress due to temperature variation are more largely improved than that of the samples B, F to I.

### (Embodiment 2)

Laser irradiation corresponding to an actual pulse laser deposition method was applied to ten samples A and B manufactured in the example 1, and chipping condition of each sample was compared.
Wherein conditions are set as follows: a laser irradiation source: excimer laser, laser irradiation condition: laser output of 400mJ, 200Hz, and laser irradiation base is fixed. In addition, the sample was moved relatively to the laser irradiation base at a speed of 10mm/sec, and the laser irradiation was performed in a 50mm x 50mm range of a central portion of each sample.

No breakage was recognized in all of the ten prepared samples A. On the other hand, breakage was recognized in all of the ten prepared samples B.
From the aforementioned results, it is found that the strength of the samples A against the strain stress due to temperature variation by laser irradiation is significantly improved, compared to the samples B.

Next, the samples A and B were prepared again, and this time, backing plates were bonded to both samples, as targets. Then, the both samples having the backing plates bonded thereto are irradiated with laser beams under the same conditions as described above, and a superconducting film of 2000Å was formed on an MgO single crystal substrate, to obtain film-formed samples A and B. When the superconductivity was measure after these film-formed samples A and B are subjected to annealing at 400°C in oxygen, both of the film-formed samples A and B have equal superconductivity.

### BRIEF DESCRIPTION OF THE DRAWINGS

FIG. 1 is a perspective diagram of a sample for structural analysis being cut from a disc-shaped RE-based oxide superconducting sintered body;
FIG. 2 is photographic data illustrating the measurement results of structural analysis using an EPMA of laser ablation samples; and
FIG. 3 shows the 3-point bending strength test results of the laser ablation samples.

## Claims

1. A laser ablation target containing an RE-based oxide superconducting sintered body expressed by a general composition formula REaBabCucOx (wherein RE refers to yttrium and/or a rare earth element), satisfying
A + b + c = 6, 0.95 < a < 1.05 and 1.505 = c / b < 1.6, with a precipitated phase of a copper oxide and/or copper-containing oxide and/or Ba-Cu compound that exists in a grain boundary of oxide superconducting crystal grains contained in the oxide superconducting sintered body.

2. The laser ablation target according to claim 1, wherein an existence ratio of said oxide superconducting crystal grains and said precipitated phase is within a range from 98:2 to 85:15.

3. A method of manufacturing the laser ablation target according to claim 1 or claim 2, comprising the steps of:
weighing and mixing an RE element-containing raw material, a Ba-containing raw material and a Cu-containing raw material to obtain a mixture;
heating the mixture for 5 to 20 hours at 880ºC to 960ºC in an atmosphere containing 10 to 30% of oxygen to obtain a calcined powder;
compression molding this calcined powder to obtain a molded product; and
heating the molded product for 10 to 50 hours at 900ºC to 980ºC in an atmosphere containing 10 to 30% of oxygen to obtain an RE-based oxide superconducting sintered body, wherein
in said step of weighing and mixing the RE-containing raw material, the Ba-containing raw material, and the Cu-containing raw material to obtain a mixture, raw materials are weighted and mixed so as to satisfy α = 6 - β - γ, 0.95 < α < 1.05 and 1.6β > γ = 1.505β, where α is the number of moles of the RE element, β is the number of moles of Ba, and γ is the number of moles of Cu contained in the raw materials, respectively.

4. A method of manufacturing the laser ablation target according to claim 1 or claim 2, comprising the steps of:
weighing and mixing an RE element-containing raw material solution, a Ba-containing raw material solution and a Cu-containing raw material solution to obtain a mixed solution;
using a wet-type coprecipitation method to separate out a mixture containing the RE, Ba and Cu elements from the mixed solution;
heating the mixture for 5 to 20 hours at 880ºC to 960ºC in an atmosphere containing 10 to 30% oxygen to obtain a calcined powder;
compression molding the calcined powder to obtain a molded product; and
heating the molded product for 10 to 50 hours at 900ºC to 980ºC in an atmosphere containing 10 to 30% oxygen to obtain an RE-based oxide superconducting sintered body, wherein
in said step of weighing and mixing an RE-containing raw material solution, a Ba-containing raw material solution, and a Cu-containing raw material solution to obtain a mixed solution, raw materials are weighted and mixed so as to satisfy α = 6 - β - γ, 0.95 < α < 1.05 and 1.6β > γ = 1.505β, where α is the number of moles of the RE element, β is the number of moles of Ba, and γ is the number of moles of Cu contained in the respective raw materials.

5. The method of manufacturing the laser ablation target according to claim 3 or claim 4, comprising the steps of:
heating the calcined powder for 5 to 50 hours at 880ºC to 960ºC in an atmosphere containing 10 to 30% oxygen to obtain a sintered powder;
pulverizing the sintered powder to obtain a sintered powder with a median diameter of 20µm or less; and
compression molding the pulverized sintered powder to obtain a molded product.

6. The method of manufacturing the laser ablation target according to any of claims 3 to 5, wherein in said step of heating the molded product to obtain an RE-based oxide superconducting sintered body, an oxygen partial pressure of atmospheric air during a temperature decreasing process after completion of the heating is set at 21% or more.
